# EUROPEAN PATENT APPLICATION

(11) **EP 0 953 856 A2**
(43) Date of publication of application: **03.11.1999**
(21) Application number: 99303034.5
(22) Date of filing: 20.04.1999
(51) Int. Cl.: G02B 6/42, H05K 5/00

(54) **Solderless optical package**

(30) Priority: 29.04.1998 US 69128
(71) Applicant: LUCENT TECHNOLOGIES INC., Murray Hill, New Jersey 07974-0636 (US)
(72) Inventor: Wolf, Robert Karl, Fleetwood, Pennsylvania 19522 (US)
(74) Representative: Johnston, Kenneth Graham

(57) **Abstract**

The invention is an optical package (10) which includes a dielectric housing (11) for enclosing optical components (12,13) and at least one printed circuit board (17) mounted to a sidewall (14) of the package. A base member (30) including a plurality of leads (31) is snap fit onto the sidewalls so that the leads exert a spring force on the metalized pads of the printed circuit board to provide a robust electrical connection without the need for soldering.

## Description

### Field of the Invention

This invention relates to optoelectronics, and in particular to a package for optical components.

### Background of the Invention

Optoelectronic packaging in general, and optical transceiver modules in particular, are being driven by the need for higher packing densities and lower costs. One way of simplifying the assembly process, and thereby reduce the cost, is to eliminate the need for solder attachment of the leads providing electrical connection to the components in the package, since solder attachment requires extra processing steps such as fluxing and cleaning the flux and the cost of equipment associated with such processes.

It is desirable to provide a low cost package which is easy to assembly and still produces a robust electrical connection to the package components.

### Summary of the Invention

The invention is an optical package including a dielectric housing for enclosing optical components, the housing including sidewalls and an opening. At least one printed circuit board including at least one metalized pad is mounted to one of the sidewalls. A base member includes at least one lead inserted therein. The base member is shaped to provide a snap fit with the sidewalls at the opening so that a portion of the lead is spring-loaded onto the contact pad to provide electrical contact with the board.

### Brief Description of the Figures

These and other features of the invention are delineated in detail in the following description. In the drawing:
Fig 1 is an exploded cross sectional view of a package in accordance with an embodiment of the invention;
Fig 2 is a cross sectional view of the assembled package in accordance with the same embodiment;
Fig 3 is a plan view of a portion of the package in accordance with an embodiment of the invention; and
Fig 4 is a schematic plan view of a portion of the package in accordance with the same embodiment.

It will be appreciated that, for purposes of illustration, these figures are not necessarily drawn to scale.

### Detailed Description

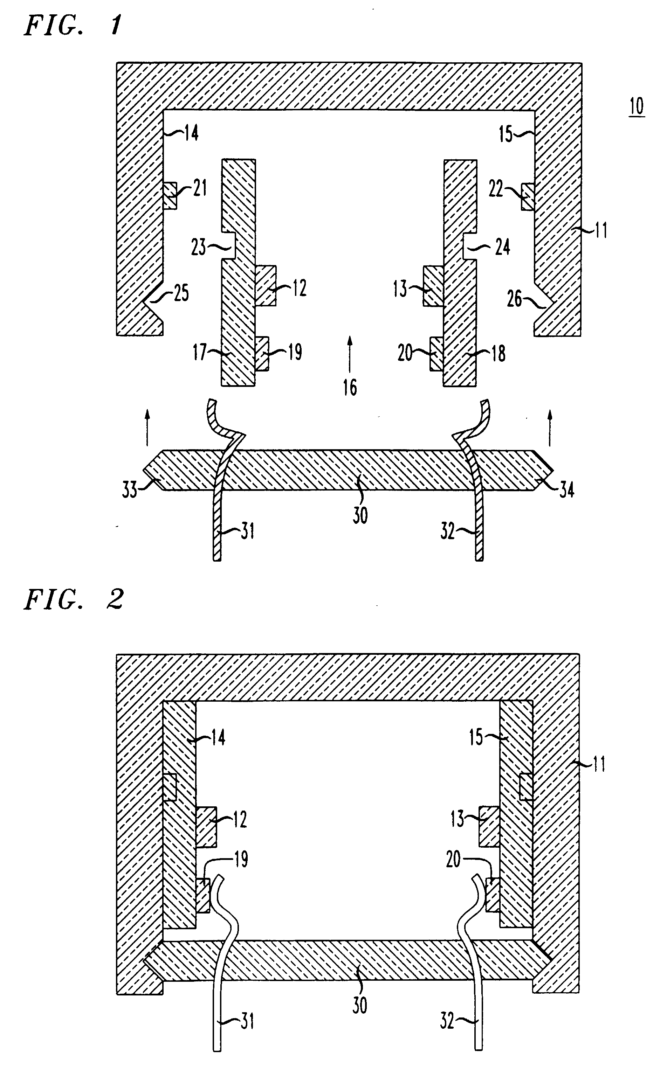

Figs 1 illustrates the assembling of the package, 10, and Fig 2 illustrates the assembled package, 10, in accordance with an exemplary embodiment. The package, 10, includes a dielectric housing, 11, for enclosing optical components, 12 and 13, the housing including sidewalls, 14 and 15, and an opening, 16. At least one printed circuit board, 17 or 18, including at least one metalized pad, 19 or 20, is mounted to one of the sidewalls, 14 or 15. A base member, 30, includes at least one lead, 31 or 32, insert-molded or press fit therein. The base member is shaped to provide a press fit with the sidewalls, 14 and 15, at the opening, 16, so that a portion of the lead, 31 or 32, is spring-loaded onto the metalized pad, 19 or 20, to provide low resistance electrical contact with the board 17 or 18.

In more detail, the dielectric housing, 11, is typically a high temperature thermoplastic material. In this embodiment, the side walls, 14 and 15, each include at least one pin, 21 and 22, respectively, extending therefrom and usually integral with the sidewalls. Each pin, 21 and 22, is designed to mate with a corresponding hole, 23 and 24, in the circuit board, 17 and 18, so that the board can be mounted securely to its corresponding sidewall by a snap-on action. The optical component, 12, in this example, is a laser such as a 1310nm MQW edge emitting laser sold under the designation Lucent 370-type laser, and the optical component, 13, is a photodetector, such as a preamplifier and pin sold under the designation Lucent 170-type detector, so that the package, 10, comprises a transceiver. Other types of optical components can be employed.

The sidewalls , 14 and 15, further include grooves, 25 and 26, positioned near the opening 16. In this example, the grooves are V-shaped, but other configurations are possible. The edges, 33 and 34, of the base member, 30, are beveled so as to fit within the grooves, 25 and 26, respectively. Thus, the base member, 30, is also mounted to the sidewalls, 14 and 15, by a snap action. The base member, 30, can also be a plastic material which is the same as or different from the material of the housing, 11.

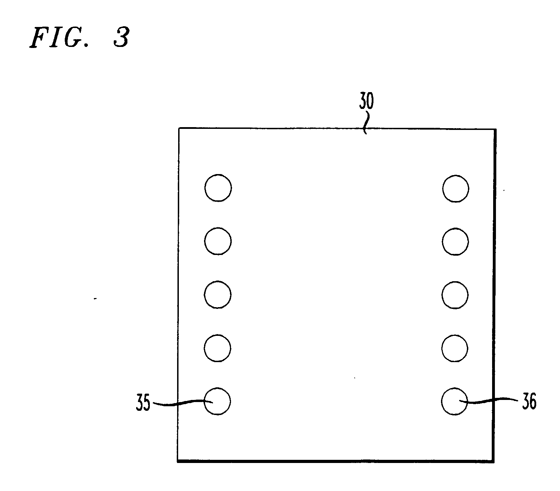

The conductive leads, 31 and 32, are typically made of BeCu selectively plated with Au. Solder plating, not shown, may also be applied to the surfaces of the leads for attachment to a mother board, also not shown. As illustrated in Fig 3, (which is a plan view of the base member, 30, with the leads removed for purposes of illustration), the leads, e.g. 31 and 32, are insert-molded or press fit within corresponding holes, e.g., 35 and 36, through the member. The holes, e.g., 35 and 36, are formed in two arrays near respective edges of the member, 30. The position of the holes, e.g., 35 and 36, and the material of the leads , e.g., 31 and 32, ensures that when the base member, 30, is snapped onto the sidewalls, 14 and 15, the leads, e.g. 31 and 32 will exert a spring force against their corresponding pads, e.g., 19 and 20, respectively, to provide robust electrical contact.

If desired, the base member, 30, can include printed circuitry (not shown) on a major surface thereof in addition to the leads, 31 and 32.

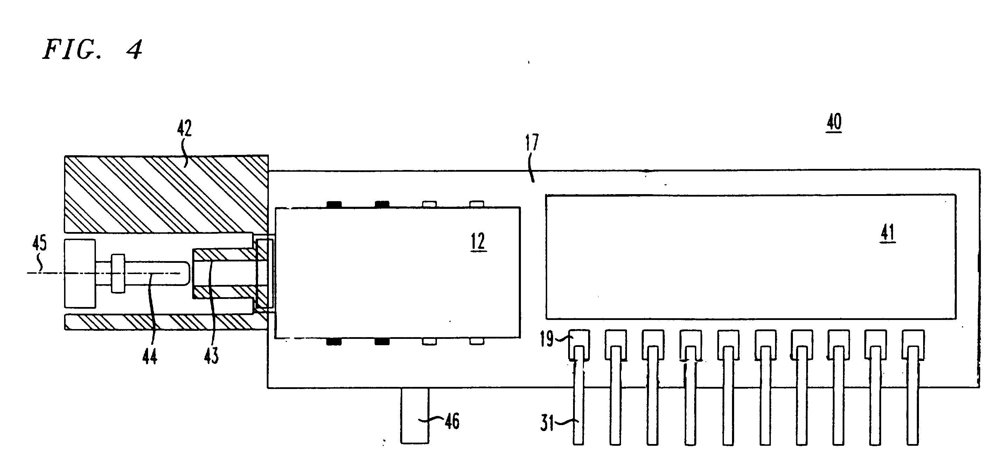

Fig 4 illustrates in a schematic plan view one example of a hybrid integrated circuit, 40, which can be enclosed within the package, 10. The hybrid circuit, 40, in this example is a transmitter circuit which includes the laser, 12, mounted near one end of the printed circuit board, 17, and extending in front of it, and electronic circuitry, illustrated by block 41, which comprises the laser drive circuitry, formed on the remainder of the board. A plurality of conductive leads, e.g., 31, is coupled to respective metalized pads, e.g. 19, as described previously to provide electrical connection to the circuitry, 41, which in turn drives the laser, 12. A standard type of optical connector receptacle, 42, such as an LC-type receptacle, is molded as an integral part of the housing 11. The receptacle, 42, includes an optical port, 43, for receiving an optical connector, 44, which connects to an optical fiber 45, so that light from the laser can be transmitted. A mounting post, 46, extending from the circuit board may also be provided for insertion in the mother board to relieve stress on the components.

A similar hybrid circuit can be mounted to the other sidewall, with the laser, 12, replaced by a photodetector (13 of Fig 1) so as to form a transceiver package.

Thus, it will be appreciated that the described package results in robust electrical connection of optical hybrid circuits without the need for soldering of leads to the bonding pads of the hybrid circuits.

## Claims

1. An optical package (10) comprising:
a dielectric housing (11) for enclosing optical components, the housing including sidewalls (14,15) and an opening (16):
characterized in that the package further comprises
at least a first printed circuit board (17) including at least a first metalized pad (19) formed thereon mounted to one of the sidewalls; and
a base member (30) including at least one lead (34) inserted therein and shaped to provide a snap fit with the sidewalls at the opening so that a portion of the lead is spring loaded onto the contact pad to provide electrical contact with the board.

2. The package according to claim 1 wherein the housing is thermoplastic.

3. The package according to claim 1 wherein the base member is thermoplastic.

4. The package according to claim 1 wherein the sidewalls each include a groove (25,26) located near the opening, and the base member includes beveled edges (33,34) which mate with the grooves to provide the snap fit.

5. The package according to claim I further comprising a second printed circuit board (18) with at least a second metalized pad (20) formed thereon, each printed circuit being mounted to a respective sidewall

6. The package according to claim 5 wherein the first printed circuit board includes a laser (12) mounted thereon, and the second printed circuit board includes a photodetector (13) mounted thereon.

7. The package according to claim 1 wherein the lead comprises BeCu selectively plated with Au.

8. The package according to claim 1 wherein the lead is insert-molded or press fitted into the base member.

9. The package according to claim 1 wherein the first printed circuit board includes a first plurality of metalized pads, and the base member includes a first plurality of leads spring loaded onto corresponding pads to provide electrical contact with the board.

10. The package according to claim 9 further comprising a second printed circuit board mounted to the other sidewall, the second board including a second plurality of metalized pads, and the base member including a second plurality of leads spring loaded onto corresponding pads of the second board to provide electrical contact with the second board.

11. The package according to claim 1 wherein the sidewall includes a pin extending (21) therefrom, and the printed circuit board includes a hole (23) which mates with the pin so that the board is snap fit onto the sidewall.
